# EUROPÄISCHE PATENTSCHRIFT

(11) **EP 2 946 644 B1**
(45) Veröffentlichungstag und Bekanntmachung des Hinweises auf die Patenterteilung: **21.09.2016**
(21) Anmeldenummer: 14700363.6
(22) Anmeldetag: 13.01.2014
(51) Int. Cl.: H05K 7/14

(54) **ANORDNUNG MIT EINEM MODUL UND EINER ELEKTRONIKANORDNUNG**
ARRANGEMENT HAVING A MODULE AND AN ELECTRONICS ARRANGEMENT
ENSEMBLE DOTÉ D'UN MODULE ET D'UN DISPOSITIF ÉLECTRONIQUE

(30) Priorität: 15.01.2013 DE 202013100208 U
(43) Veröffentlichungstag der Anmeldung: 25.11.2015
(73) Patentinhaber: Weidmüller Interface GmbH & Co. KG, 32758 Detmold (DE)
(72) Erfinder: BUSCH, Gerald, 32791 Lage (DE); SALTAJI, Safwan, 30627 Hannover (DE); DREIFERT, Sascha, 33100 Paderborn (DE)
(74) Vertreter: Specht, Peter
(86) Internationale Anmeldenummer: PCT/EP2014/050432
(87) Internationale Veröffentlichungsnummer: WO 2014/111323

(56) Entgegenhaltungen:
- DE-A1- 19 515 923
- DE-A1-102010 046 990
- DE-B3- 10 230 292
- DE-U1-202007 011 112
- DE-U1-202008 002 113
- DE-U1-202009 002 498

## Beschreibung

Die vorliegende Erfindung betrifft eine Anordnung nach dem Oberbegriff des Anspruchs 1.

Eine gattungsgemäße Anordnung offenbart die DE 10 2010 046 990 A1. In der Fertigungstechnik werden häufig Fertigungsaufgaben durch verschiedene Fertigungsmittel ausgeführt. Die Fertigungsmittel werden zumeist mithilfe von Steuersignalen gesteuert, die von einer Steuerplatine aus zur Verfügung gestellt werden. Dafür sind den Fertigungsmitteln Steuermodule zugeordnet, wobei die Steuersignale, beispielsweise über einen Bus, zwischen der Steuerplatine und den Steuermodulen hin und her übertragen werden. Einerseits bestehen für die Übertragung der Steuersignale hohe Sicherheitsanforderungen, die für die elektrische und mechanische Ausbildung der Anschlussmittel eine große Herausforderung darstellen. Andererseits erfordert das Ändern der Fertigungsaufgabe häufig ein Umrüsten der Steuermodule. Daher besteht ein Bedarf an einer schnell und leicht umrüstbaren Anschlusstechnik für die Module.

Die Druckschrift EP 1 520 330 B1 offenbart zum Verbinden solcher Steuermodule mit einer Steuerplatine einen etwa L- förmigen Träger, auf den die Module mit einer Schwenkbewegung aufsteckbar sind. Bei dieser Lösung ist die Anschlusstechnik sehr komplex ausgebildet und die Schwenkbewegung schwierig durchführbar.

Aus anderem Stand der Technik ist es zudem bekannt, die Verbindung mittels flexibler Leitungen zu realisieren, was relativ aufwendig und unübersichtlich ist. Einen Adapter offenbart die DE 195 15 923 A1.

Aufgabe der Erfindung ist es, eine platzsparende und kostengünstige Anordnung mit einem elektrischen Anschluss- und/oder Steuermodul und einer Elektronikanordnung, insbesondere Leiterplattenanordnung zu schaffen, die den hohen Sicherheitsanforderungen genügt, ein sehr schnelles und einfaches Umrüsten des Anschluss- und/oder Steuermoduls ermöglicht, und unter Fertigungsbedingungen, insbesondere bei starker Vibrationsbelastung und extremen Temperaturen, einen dauerhaften Betrieb des Anschluss- und/oder Steuermoduls gewährleistet.

Die Aufgabe wird mit dem Gegenstand des Anspruchs 1 gelöst Vorteilhafte Ausführungsformen sind den Unteransprüchen zu entnehmen.

Es wird ein Adapter geschaffen, der zum Verbinden eines elektrischen Anschlussmoduls insbesondere mit einer elektrischen Leiterplatte einer Leiterplattenanordnung dient. Der Adapter weist mindestens einen ersten Anschlussstecker und einen zweiten Anschlussstecker auf. Die Anschlussstecker sind in einem Adaptergehäuse angeordnet und elektrisch miteinander verbunden. Dabei ist sowohl eine Ausführungsform umfasst, bei der die Anschlussstecker unmittelbar miteinander verbunden sind, als auch eine Ausführungsform, bei der der Adapter elektrische Bauteile umfasst, beispielsweise ein Filter oder ähnlich, die zwischen den Anschlusssteckern angeordnet sind.

Der Winkel α ist größer als 0° und beträgt erfindungsgemäß für eine vorteilhafte Handhabung 20° - 70°, besonders bevorzugt 30° - 50°. Außerdem ist es bevorzugt, dass die Erstreckungsrichtung eine vertikale Richtung ist. Diese Anordnung ermöglicht ein sehr leichtes Aufschieben des Adapters auf die Leiterplatte und das Anschlussmodul von oben.

Es ist bevorzugt, dass der Adapter zumindest zwei zweite Anschlussstecker aufweist, die beide in dem Winkel und außerdem höhenversetzt zueinander angeordnet sind.

Vorzugsweise weist der Adapter ein Adaptergehäuse auf, insbesondere aus einem starren Kunststoff, so dass er einfach und sicher handhabbar ist. Gerade gegenüber einer Lösung mit biegsamen Kabeln nach Art der DE 10 2010 046 990 B wird derart die Montage deutlich vereinfacht.

Vorzugsweise liegt der Adapter im montierten Zustand am Anschlussmodul an/ auf.

Um die Belüftung des Anschlussmoduls zu gewährleisten, ist es in einer Ausführungsform, die die Aufgabe weiterhin löst, bevorzugt, dass im Adaptergehäuse wenigstens eine Lüftungsöffnung oder mehrere Lüftungsschlitze, insbesondere zum Belüften des Anschlussmoduls, vorgesehen ist oder sind. Dadurch wird bei am Anschlussmodul montiertem Adapter eine Überhitzung des Anschlussmoduls vermieden.

In einer bevorzugten Ausführungsform umfassen der erste und/oder die zweiten Anschlussstecker zumindest teilweise zwei oder mehr elektrische Kontakte. Besonders bevorzugt umfasst der Adapter vier erste Anschlussstecker mit jeweils zwei elektrischen Kontakten. Die elektrischen Kontakte sind bevorzugt als doppelseitig isolierte Stecker ausgebildet. Bei dieser Ausführungsform wird mittels der vier ersten Anschlussstecker eine 8- adrige Verbindung ermöglicht. Die Stecker können mit Stromschienen verbunden sein oder als die Enden von Stromschienen ausgebildet sein.

In einer besonders bevorzugten Ausführungsform umfasst der Adapter einen ersten Adapterteil und einen zweiten Adapterteil, wobei der erste oder die ersten Anschlussstecker am ersten Adapterteil und der zweite oder die zweiten Anschlussstecker am zweiten Adapterteil angeordnet sind. Die Adapterteile sind bevorzugt lösbar voneinander vorgesehen. Besonders bevorzugt sind sie in-, an oder aufeinander steckbar oder schiebbar. Ganz besonders bevorzugt ist der zweite Adapterteil auf den ersten Adapterteil aufsteckbar. In dieser Ausführungsform sind die Adapterteile unabhängig voneinander oder gemeinsam handhabbar.

Um elektrische Verbindungen zwischen dem oder den ersten Anschlusssteckern und dem oder den zweiten Anschlusssteckern herzustellen, ist es dafür bevorzugt, dass am zweiten Adapterteil ein oder mehrere erste elektrische Zwischenstecker vorgesehen sind, die an einen oder mehrere erste elektrische Zwischengegenstecker des ersten Adapterteils anschließbar sind. Die ersten Zwischenstecker sind vorzugsweise parallel dem oder den zweiten Anschlusssteckern angeordnet. Sie weisen daher den Winkel zur Erstreckungsrichtung auf. In dieser Ausführungsform ist ein Anschließen des Adapters besonders einfach, indem der erste Adapterteil unabhängig vom zweiten Adapterteil gehandhabt wird.

Der erste Zwischenstecker und der erste Zwischengegenstecker sind bevorzugt als Push in Stecker und dazu korrespondierende Buchse ausgebildet. Dabei kann sowohl der erste Zwischenstecker als Stecker und der erste Zwischengegenstecker als Buchse ausgebildet sein, oder umgekehrt. Anstelle eines Push in Steckers, der eine hohe Kontaktsicherheit bietet und sehr leicht montierbar ist, ist zudem auch eine andere Anschlusstechnik möglich, beispielsweise eine Ausbildung der ersten Zwischenstecker und der ersten Zwischengegenstecker als Kontaktflächen.

Um die Handhabung des Adapters noch weiter zu vereinfachen, ist am zweiten Adapterteil eine Handhabung, vorzugsweise ein Hebel, vorgesehen, der ein Herausheben des zweiten Adapterteils aus einem Anschlussmodul ermöglicht, in das dieses eingesteckt ist.

Die Aufgabe wird weiterhin gelöst mit einer Anordnung mit einem solchen Adapter, einem elektrischen Anschlussmodul und einer Leiterplattenanordnung, insbesondere einer elektrischen Leiterplatte der Leiterplattenanordnung. Die elektrische Leiterplatte umfasst bevorzugt einen Leiterbus. Der Adapter ist daher zum elektrischen Verbinden des elektrischen Anschlussmoduls mit dem Leiterbus vorgesehen. Dabei ist es bevorzugt, dass der Leiterbus als Interface- Platine ausgebildet ist, die gegebenenfalls eine elektrische Schaltung umfasst. In dieser Ausführungsform wird der Leiterbus, beispielsweise über ein Kabel, mit einer Steuerplatine verbunden, die sowohl innerhalb der Leiterplattenanordnung als auch außerhalb der Leiterplattenanordnung angeordnet sein kann. Ebenfalls bevorzugt ist der Leiterbus als ein mehradriges Kabel vorgesehen.

Die Leiterplattenanordnung weist bevorzugt mehrere nebeneinander angeordnete Einschubräume auf, die jeweils zur Aufnahme eines elektrischen Anschlussmoduls vorgesehen sind.

Die Einschubräume sind bevorzugt jeweils durch eine Trennwand von ihren benachbarten Einschubräumen getrennt. Zudem ist in jedem Einschubraum bevorzugt eine Rückwand vorgesehen. Die Trennwände und die Rückwand erleichtern das Positionieren eines Anschlussmoduls in seinem Einschubraum.

Zum elektrischen Anschließen des Adapters insbesondere an die Leiterplatte der Leiterplattenanordnung ist bevorzugt in jedem Einschubraum ein erster Anschlussgegenstecker vorgesehen, der korrespondierend zu dem ersten Anschlussstecker des Adapters ausgebildet ist. Ebenfalls bevorzugt umfasst jedes Anschlussmodul zumindest einen zweiten Anschlussgegenstecker, der korrespondierend zu dem oder den zweiten Anschlusssteckern des Adapters ausgebildet ist, um den Adapter an das Anschlussmodul anzuschließen. Der Anschlussstecker und der Anschlussgegenstecker sind bevorzugt als Push in Stecker und dazu korrespondierende Buchse ausgebildet. Dabei kann sowohl der Anschlussstecker als Stecker und der Anschlussgegenstecker als Buchse ausgebildet sein, oder umgekehrt. Anstelle eines Push in Steckers, der eine hohe Kontaktsicherheit bietet und sehr leicht montierbar ist, ist zudem auch eine andere Anschlusstechnik möglich, beispielsweise eine Ausbildung der Anschlussstecker und der Anschlussgegenstecker als Kontaktflächen.

In einer alternativen Ausbildung der Leiterplattenanordnung ist es ebenfalls bevorzugt, dass diese ein erstes Anschlussfeld, insbesondere ein Steckfeld, beispielsweise eine Lochplatine, aufweist, an das der erste oder die ersten Anschlussstecker anschließbar sind. Diese Ausbildung hat den Vorteil, dass elektrische Anschlüsse der Leiterplattenanordnung, insbesondere der Leiterbus, in einem Gehäuseinnenraum der Leiterplattenanordnung angeordnet sind, und daher elektrisch isoliert und/oder staub- und/oder feuchtigkeitsgeschützt sind.
Um die Anschlussmodule zu befestigen, ist es bevorzugt, dass die Elektronikanordnung, insbesondere Leiterplattenanordnung, eine erste Tragschiene umfasst, an der die Anschlussmodul aneinander gereiht und lösbar befestigbar sind. Dabei ist es bevorzugt, dass jedes Anschlussmodul ein Betätigungsmittel zum Lösen des Anschlussmoduls von der ersten Tragschiene umfasst.

In einer bevorzugten Ausführungsform ist an der ersten Tragschiene ein Anschlussbus vorgesehen. Der Anschlussbus ist bevorzugt für die Spannungsversorgung der Anschlussmodule vorgesehen. Zudem umfasst er ebenfalls bevorzugt weitere Signalleitungen für die Anschlussmodule.

Im montierten Zustand ist es bevorzugt, dass jeweils ein Anschlussmodul in einem Einschubraum angeordnet und an der ersten Tragschiene befestigt ist. Zudem ist der Adapter auf das Anschlussmodul und die Leiterplattenanordnung aufgeschoben. Dabei liegt er bevorzugt am Anschlussmodul an. Ebenfalls bevorzugt ist der Adapter quer zur Leiterplatine und parallel des elektrischen Anschlussmoduls angeordnet. Bei dieser Anordnung erschwert der Winkel zwischen den ersten und zweiten Anschlusssteckern ein Loswackeln des Adapters. Dadurch können sich auch die Anschlussstecker nicht aus den Anschlussgegensteckern loswackeln, so dass der elektrische Kontakt auch unter starker Vibrationsbeiastung sicher gewährleistet ist.

In der alternativen Ausführungsform, in der die Leiterplattenanordnung das erste Anschlussfeld umfasst, ist das Anschlussmodul vorzugsweise ebenfalls an der ersten Tragschiene befestigt. Zudem ist der Adapter bevorzugt auf das Anschlussmodul und das erste Anschlussfeld der Leiterplattenanordnung aufgesteckt. Dabei liegt er ebenfalls bevorzugt am Anschlussmodul an. Diese Ausführungsform ist besonders einfach handhabbar, indem zunächst der erste Adapterteil, vorzugsweise durch Aufstecken oder Aufschieben in die Erstreckungsrichtung, auf das erste Anschlussfeld, und anschließend der zweite Adapterteil, vorzugsweise durch Aufstecken oder Aufschieben in eine Einsteckrichtung, die in dem Winkel zur Erstreckungsrichtung verläuft, auf das Anschlussmodul und den ersten Adapterteil aufgesteckt wird.

Die Lüftungsöffnung im Adapter verhindert zudem eine Überhitzung des Anschlussmoduls auch bei hohen Außentemperaturen.

Geschaffen wird auch ein Verfahren zum Montieren eines elektrischen Anschlussmoduls an einer Elektronikanordnung, insbesondere Leiterplattenanordnung mit den Schritten:
- Aufrasten des Anschlussmoduls auf die erste Tragschiene der Elektronikanordnung, insbesondere Leiterplattenanordnung,
- Anordnen des Adapters an der Elektronikanordnung, insbesondere Leiterplattenanordnung, so dass der erste Anschlussstecker mit dem ersten Anschlussgegenstecker der Elektronikanordnung, insbesondere Leiterplattenanordnung, und der zweite Anschlussstecker mit dem zweiten Anschlussgegenstecker des elektrischen Anschlussmoduls zusammengesteckt werden, bis der Adapter am elektrischen Anschlussmodul anliegt.

Die elektrische Verbindung wird daher durch einfaches Aufstecken dauerhaft sicher hergestellt. Bei einem Umrüsten muss der Adapter lediglich gegen die Einsteckrichtung herausgezogen werden. Dies ist auch bei der zweiteiligen Ausführungsform des Adapters sehr schnell durch die vereinfachte Handhabung mit Hilfe des Hebels möglich. Danach ist das Anschlussmodul mithilfe des Betätigungsmittels von der ersten Tragschiene lösbar. Das Umrüsten ist daher sehr schnell und einfach möglich.

Nachfolgend wird die Erfindung unter Bezug auf die Zeichnungen anhand von Ausführungsbeispielen näher erläutert, wobei weitere Vorteile der Erfindung deutlich werden. Es zeigt:
- Fig. 1: in (a) - (c) einen Adapter in zwei verschiedenen Seitenansichten und einer Rückansicht,
- Fig. 2: in (a) das Einstecken des Adapters in ein Anschlussmodul und in (b) den an das Anschlussmodul angeschlossenen Adapter,
- Fig. 3: eine Anordnung mit dem Anschlussmodul, dem Adapter und einer Leiterplatte im montierten Zustand,
- Fig. 4: zeigt den zweiten Adapterteil einer zweiteiligen Ausführungsform des Adapters, und zwar in (a) in einer ersten perspektivischen Ansicht, in (b) in einer Seitenansicht, in (c) eine Steckseite des zweiten Adapterteils, in (d) eine Rückseite des zweiten Adapterteils, in (e) in einer weiteren Seitenansicht, in (f) eine weitere Ansicht der Rückseite und in (g) einen Schnitt A-A durch die Ansicht (f),
- Fig. 5: zeigt eine Anordnung aus einem Anschlussmodul, einer weiteren Ausführungsform der Elektronikanordnung und dem zweiteiligen Adapter der Fig. 4, und zwar in (a) in einer perspektivischen Ansicht, und in (b) - (d) jeweils in Seitenansichten,
- Fig. 6: zeigt den zweiten Adapterteil einer weiteren zweiteiligen Ausführungsform des Adapters, und zwar in (a) in einer ersten perspektivischen Ansicht, in (b) in einer Seitenansicht, in (c) eine Steckseite des zweiten Adapterteils, in (d) eine Rückseite des zweiten Adapterteils, in (e) einen zweiten Adaptergehäuseteil des zweiten Adapterteil in einer perspektivischen Ansicht, und in (f) den Innenraum des zweiten Adaptergehäuseteils,
- Fig. 7: zeigt ein in (a) und (b) ein zwischen den zweiten Adapterteil und das Anschlussmodul anordbares Zwischenmodul, in (c) und (d) eine weitere Ausführungsform des zweiten Adapterteils, in (e) und (f) das am Zwischenmodul angeordnete zweite Adapterteil, in (g) eine explosionsartige Darstellung des Anschlussmoduls, des Zwischenmoduls und des zweiten Adapterteils, und in (h) das zwischen das Anschlussmodul und den zweiten Adapterteil montierte Zwischenmodul,
- Fig. 8: zeigt eine Anordnung aus dem Anschlussmodul, dem Zwischenmodul und dem zweiten Adapterteil der Fig. 7 (h) an der Elektronikanordnung aus Fig. 5, und zwar in (a) in einer perspektivischen Ansicht, und in (b) - (d) jeweils in Seitenansichten, und
- Fig. 9: zeigt eine erste Ausführungsform des ersten Adapterteils der Fig. 5 (a).

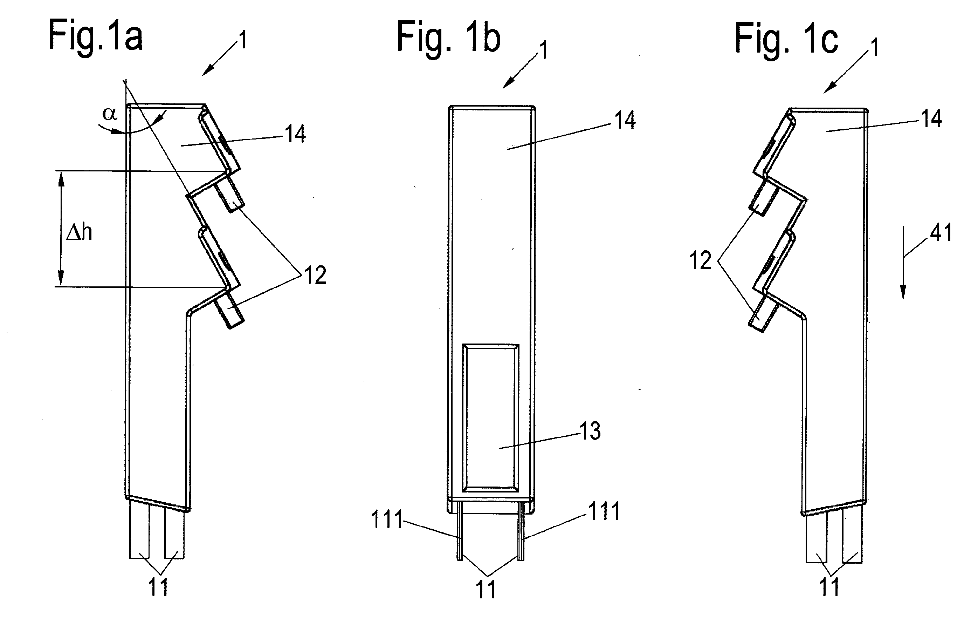

Fig. 1 zeigt einen Adapter 1 zum Verbinden eines elektrischen Anschlussmoduls 2 mit einer elektrischen Elektronikanordnung, insbesondere einer Leiterplattenanordnung 3 mit einer Leiterplatte oder beispielsweise einem Stanzgitter. Ein elektrisches Anschlussmodul 2 ist beispielsweise ein Steuermodule, dass in der Fertigungstechnik zum Steuern eines ihm zugeordneten Fertigungsmittels (nicht gezeigt) vorgesehen ist. Eine elektrische Elektronikanordnung, insbesondere Leiterplattenanordnung, 3 weist bevorzugt einen Leiterbus (nicht gezeigt) auf, der mit einer Steuerplatine (nicht gezeigt) zum Steuern mehrerer solcher Anschlussmodule 2 beziehungsweise Fertigungsmittel vorgesehen ist. Oder ebenfalls bevorzugt umfasst sie eine solche Steuerplatine.

Der Adapter 1 ist zum sicheren elektrischen Verbinden des Leiterbusses beziehungsweise der Steuerplatine der Leiterplattenanordnung mit dem elektrischen Anschlussmodul 2 vorgesehen. Er führt bevorzugt Signalleitungen 11, 12, kann aber auch für Versorgungsleitungen ausgebildet sein.

Zum Anschließen des Adapters 1 an die Leiterplatte 3 beziehungsweise den Leiterbus der Elektronikanordnung, insbesondere der Leiterplattenanordnung, 3 weist dieser erste Anschlussstecker 11 auf, die hier als Push in Stecker ausgebildet sind. Die ersten Anschlussstecker 11 sind in zwei Reihen angeordnet. Insgesamt sind bei diesem Adapter 1 vier erste Anschlussstecker 11 vorgesehen, die jeweils zwei doppelseitig isolierte elektrische Kontakte 111 aufweisen. Dadurch ist hier über die vier ersten Anschlussstecker 11 eine achtadrige Verbindung realisierbar.

Zum Anschließen des Adapters 1 an das Anschlussmodul 2 sind zweite Anschlussstecker 12 vorgesehen. Die zweiten Anschlussstecker 12 sind in zwei zueinander um einen Höhenversatz Δh versetzten Reihen angeordnet. Zudem weisen die zweiten Anschlussstecker 12 einen Winkel α zu den ersten Anschlusssteckern 11 auf.

In einem Montagezustand M erstreckt sich der Adapter 1 in eine vertikale Erstreckungsrichtung 41, so dass die ersten und zweiten Anschlussstecker 11, 12 nach unten gerichtet angeordnet sind.

Die ersten und zweiten Anschlussstecker 11, 12 sind in einem Adaptergehäuse 14 angeordnet, dass vorzugsweise starr ausgebildet ist und vorzugsweise aus einem Isolierstoff (insbesondere einem Kunststoff) besteht. Um ein Belüften des Anschlussmoduls 2 im Montagezustand M zu ermöglichen, ist im Adaptergehäuse 14 eine Lüftungsöffnung 13 vorgesehen.

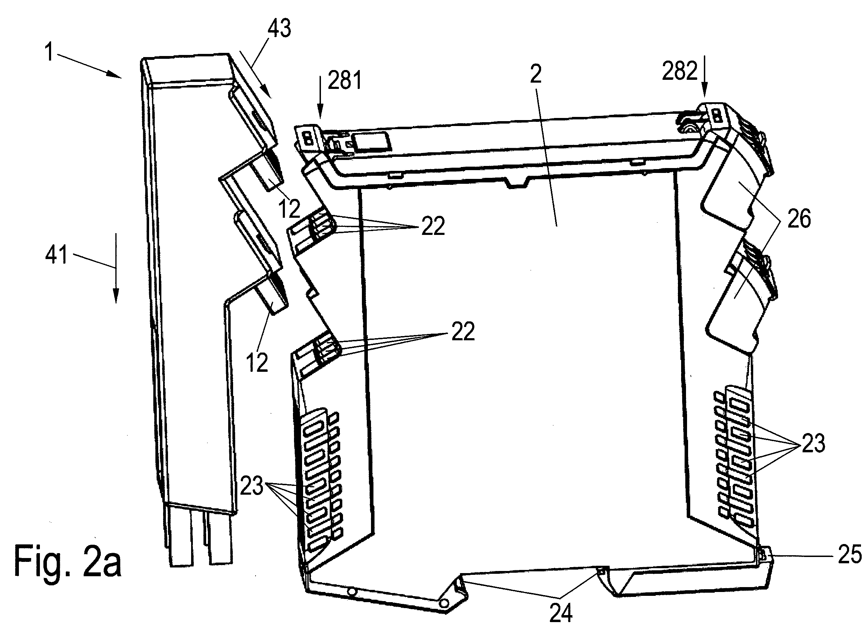

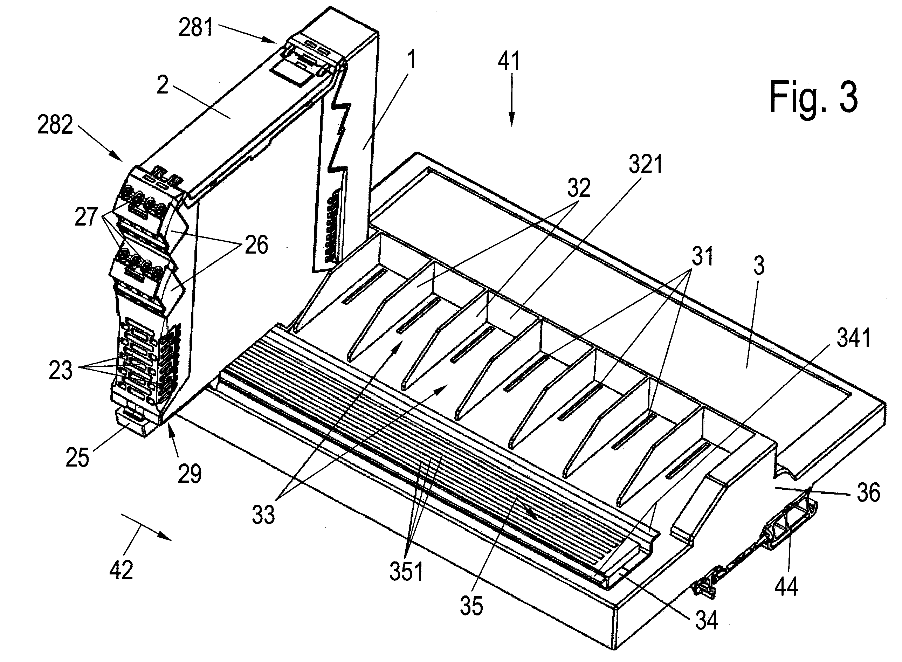

Fig. 2a zeigt das Anordnen des Adapters 1 an eine Adapterseite 281 eines elektrischen Anschlussmoduls 2. An einer der Adapterseite 281 gegenüberliegenden Anschlussseite 282 sind Steckanschlüsse 26 vorgesehen, die einem Benutzer Standard-Anschlussstecker 27 (s. Fig. 3) zur Verfügung stellen.

An der Adapterseite 281 weist das elektrische Anschlussmodul 2 zweite Anschlussgegenstecker 22 auf, die in demselben Winkel α zu den ersten Anschlusssteckern 11 angeordnet sind. Auch die zweiten Anschlussgegenstecker 22 sind in zwei Reihen angeordnet, die den Höhenversatz Δh zueinander aufweisen. Da sich bei dieser Ausführungsform der Adapter 1 im Montagezustand M in die vertikale Richtung erstreckt, ist der Winkel α hier ein Winkel α zu Vertikalen.
Die zweiten Anschlussgegenstecker 22 sind in dieser Ausführungsform als Buchsen ausgebildet. Es ist aber auch eine Ausführungsform denkbar, bei der die zweiten Anschlussstecker 12 als Buchsen und die zweiten Anschlussgegenstecker 22 als Stecker ausgebildet sind.

In dieser Fig. 2a ist sichtbar, dass der Adapter 1 acht einpolige zweite Anschlussstecker 12 aufweist. Es ist aber auch eine Ausführungsform denkbar, bei der die zweiten Anschlussstecker 12 analog zu den ersten Anschlusssteckern 11 des Adapters 1 zwei voneinander isolierte elektrische Kontakte (nicht gezeigt) aufweisen.

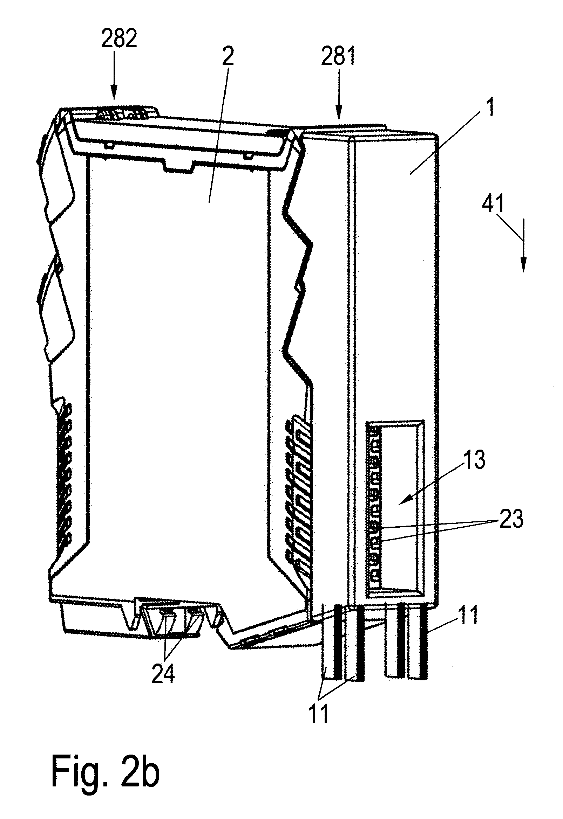

Durch ein Verschieben des Adapters 1 in eine Einsteckrichtung 43, die den Winkel α zur Vertikalen aufweist, sind die zweiten Anschlussstecker 12 in die zweiten Anschlussgegenstecker 22 einsteckbar. In der Fig. 2b ist der am Anschlussmodul 2 angeordnete Adapter 1 gezeigt. Die Fig. 2b zeigt daher den Montagezustand M, aber ohne die Leiterplatte 3.

Zum Befestigen des Anschlussmoduls 2 an der eine Leiterplatte aufweisenden Elektronikanordnung, insbesondere Leiterplattenanordnung, 3 (s. Fig. 3) sind Rastmittel 24 vorgesehen, mit der das Anschlussmodul 2 an einer ersten Tragschiene 34 (s. Fig. 3) der Elektronikanordnung, insbesondere Leiterplattenanordnung, 3 verrastbar ist. Zudem ist ein Betätigungsmittel 25 zum Lösen der Verrastung vorgesehen, so dass das Anschlussmodul 2 von der Leiterplatte 3 wieder lösbar ist. Das Betätigungsmittel 25 ist an der Anschlussseite 282 des Anschlussmoduls 2 angeordnet. Dadurch ist es für einen Bediener leicht zugänglich.

Um die Elektronik des Anschlussmoduls 2 ausreichend zu Belüften, sind Kühlöffnungen 23 vorgesehen, durch die kühle Luft in das Anschlussmodul 2 einströmen und warme Luft aus dem Anschlussmodul 2 ausströmen kann. Im montierten Zustand M liegt der Adapter 1 am Anschlussmodul 2 an. Um die Kühlung in diesem Zustand M weiterhin zu gewährleisten, ist die Lüftungsöffnung 13 im Adapter 1 vorgesehen, die den Luftaustausch auch bei angeschlossenem Adapter 1 ermöglicht.

In der Fig. 3 ist eine Anordnung mit dem Anschlussmodul 2, der Elektronikanordnung, insbesondere Leiterplattenanordnung, 3 und dem Adapter 1 gezeigt. Auch diese Fig. 3 zeigt den Montagezustand M.

Der Adapter 1 und das Anschlussmodul 2 erstrecken sich hier in die vertikale Richtung, die Leiterplatte 3 parallel der Horizontalen.

An der Elektronikanordnung, insbesondere der Leiterplattenanordnung oder einer Stanzgitteranordnung oder dgl., 3 ist eine erste Tragschiene 34 angeordnet, die sich in eine Tragschienenrichtung 42 erstreckt. Die Tragschiene 34 ist zum Befestigen mehrerer Anschlussmodule 2 vorgesehen. Um das nebeneinander Positionieren der Anschlussmodule 2 zu erleichtern, weist die Elektronikanordnung, insbesondere Leiterplattenanordnung, 3, auch Backplane genannt, Einschubräume 33 auf. Die Einschubräume 33 sind in Tragschienenrichtung 42 nebeneinander angeordnet und durch Trennwände 32 voneinander getrennt. Zudem weisen sie eine Rückwand 321 auf.

Die erste Tragschiene 34 ist hutförmig ausgebildet und weist zwei voneinander beabstandete Rastschenkel 341 auf. Zum Befestigen der Anschlussmodule 2 an der Leiterplatte 3 hintergreifen die Rastmittel 24 (s. Fig. 2b) der Anschlussmodule 2 die Rastschenkel 341.

In der hier gezeigten Ausführungsform der Anordnung wird ein Zwischenraum zwischen den Rastschenkeln 341 für einen Anschlussbus 35 genutzt, der den Anschlussmodulen 2 eine Versorgungsspannung und weitere Signale zuführt. Dafür weist der Anschlussbus 35 mehrere Leiterbahnen 351 auf, die die Anschlussmodule 2 an ihrer Unterseite 29 abgreifen.

In den Einschubräumen 33 sind erste Anschlussgegenstecker 31 vorgesehen, an die die ersten Anschlussstecker 11 des Adapters 1 anschließbar sind. Die ersten Anschlussgegenstecker 31 sind hier als Buchsen ausgebildet. Von ihnen sind hier daher die Einschuböffnungen sichtbar.

Prinzipiell ist auch eine Ausführungsform des Adapters 1 und der Elektronikanordnung, insbesondere Leiterplattenanordnung, 3 denkbar, bei der die ersten Anschlussstecker 11 als Buchsen und die ersten Anschlussgegenstecker 31 als Stecker ausgebildet sind.

Die Elektronikanordnung, insbesondere Leiterplattenanordnung, 3 weist ein Gehäuse, vorzugsweise ein Leiterplattengehäuse 36 auf, in dem der Leiterbus und/oder die Steuerplatine/-Leiterplatte angeordnet sind. Da die ersten Anschlussstecker 11 hier eine achtadrige Verbindung ermöglichen, ist der Leiterbus bevorzugt zumindest achtadrig ausgebildet.

Sichtbar ist zudem, dass die Elektronikanordnung, insbesondere Leiterplattenanordnung, 3 an einer zweiten, externen Tragschiene 44 angeordnet ist.

Zum Anschließen des Anschlussmoduls 2 an die Elektronikanordnung, insbesondere Leiterplattenanordnung, 3 wird bei dieser Anordnung das Anschlussmodul 2 im Einschubraum 33 positioniert. Dann wird es auf die erste, vorzugsweise separat zum Leiterplattengehäuse gefertigte und dann an diesem festgelegte Tragschiene 34 aufgerastet.

Anschließend wird der Adapter 1 auf die Anordnung aufgeschoben. Dabei wird er in Einsteckrichtung 43, hier in dem Winkel α zur Vertikalen, nach unten verschoben. Dabei werden die ersten und zweiten Anschlussstecker 11, 92 in die ersten Anschlussgegenstecker 31 der Elektronikanordnung, insbesondere Leiterplattenanordnung, 3 und die zweiten Anschlussgegenstecker 22 des Anschlussmoduls 2 eingeschoben. Der Adapter 1 wird dabei solange in die Einsteckrichtung 43 verschoben, bis er am Anschlussmodul 2 anliegt.

Beim Umrüsten wird der Adapter 1 der Anordnung durch ein Verschieben gegen die Einsteckrichtung 43 entnommen. Anschließend ist das Anschlussmodul 2 von der ersten Tragschiene 34 abhebbar, indem das Betätigungsmittel 25 betätigt wird.

Der Adapter 1 ermöglicht eine mehradrige Busverbindung für Signalleitungen und gegebenenfalls auch Versorgungsleitungen zwischen der Elektronikanordnung, insbesondere Leiterplattenanordnung, 3 und dem Anschlussmodul 2. Durch das Adaptergehäuse 14 ist die Busverbindung gegen Staub, Feuchtigkeit und direkte mechanische Einwirkungen geschützt. Aufgrund des Winkels α, in dem der Adapter 1 auf das Anschlussmodul 2 aufgeschoben ist, ist die elektrische Verbindung auch bei starker Vibrationsbelastung gewährleistet. Um die Sicherheit gegen ein Loswackeln noch zu vergrößern, ist es denkbar, den Adapter 1 zusätzlich am Anschlussmodul 2 zu befestigen, beispielsweise durch Verrasten.

Es kann zwischen dem wenigstens einen ersten Anschlussstecker 11 und dem wenigstens einen zweiten Anschlussstecker 12 wenigstens ein elastisches Element, insbesondere ein Federelement, vorgesehen sein.

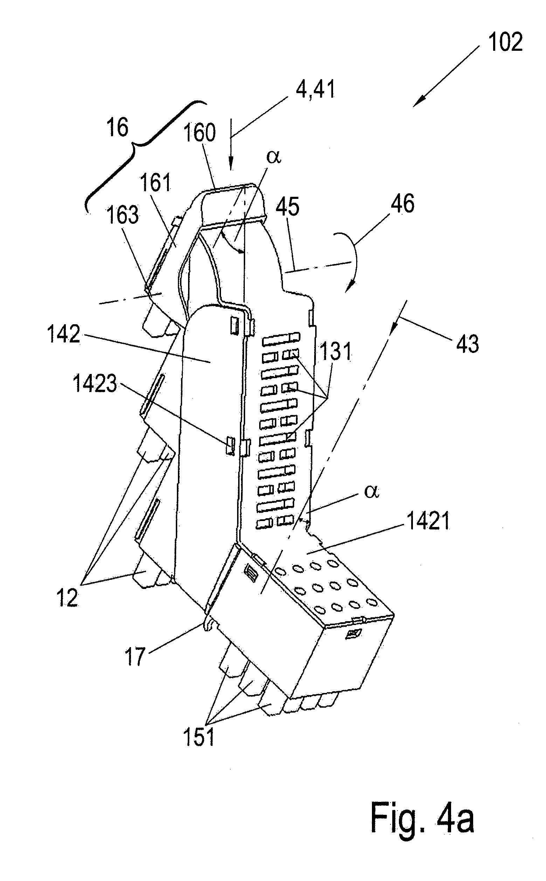

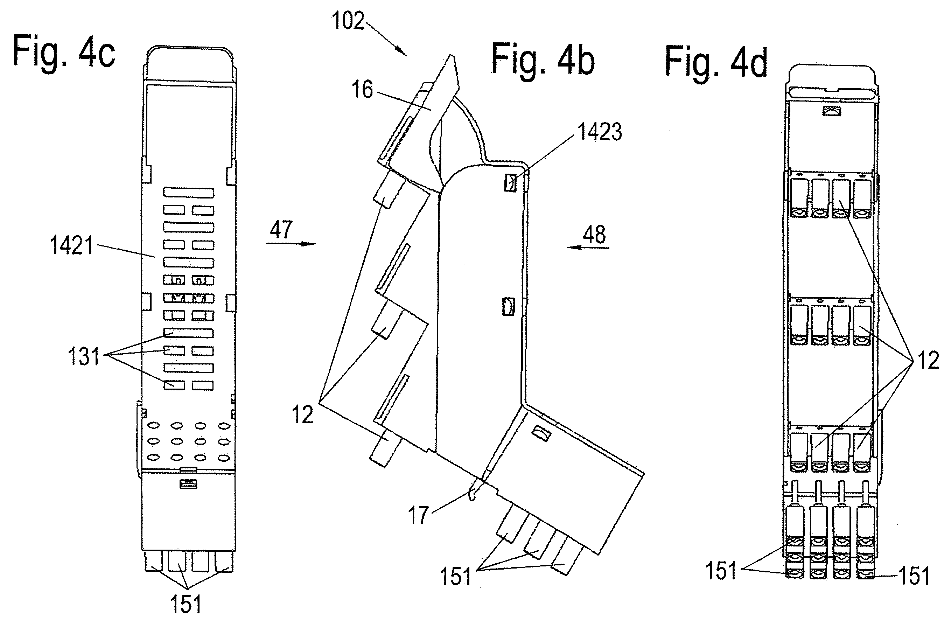

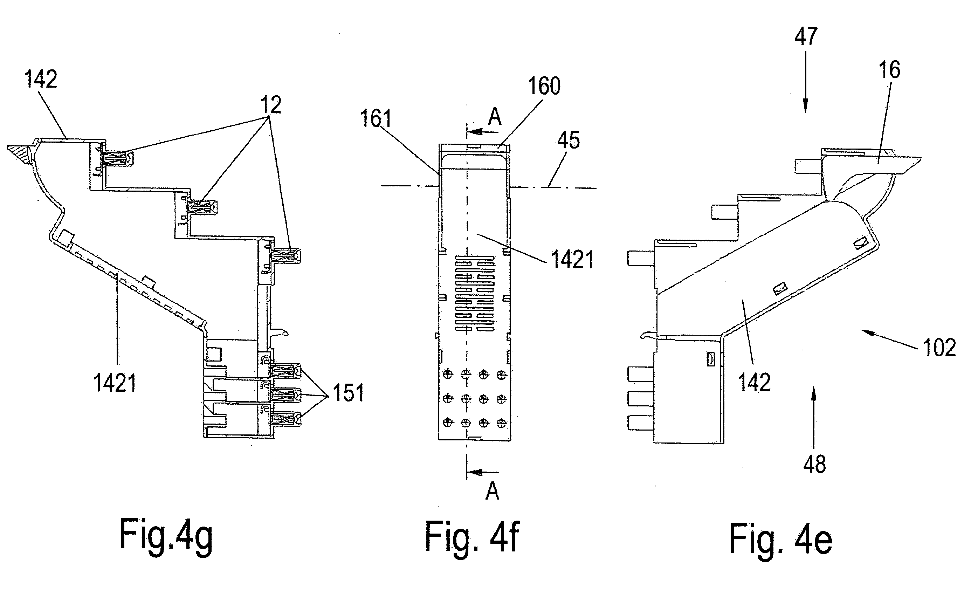

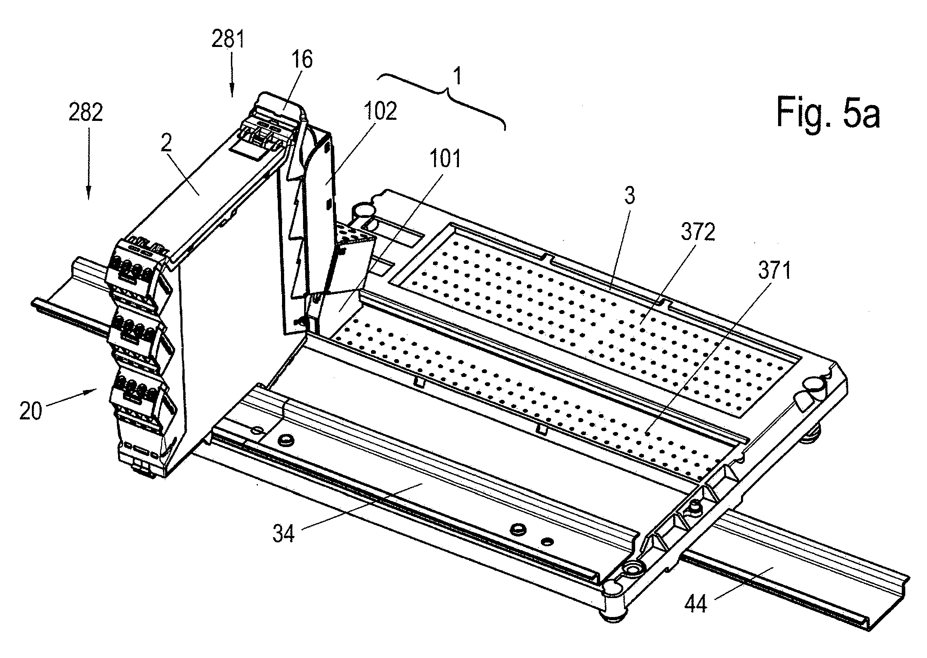

Fig. 4 zeigt in (a) - (g) einen zweiten Adapterteil 102 einer zweiteiligen Ausführungsform des Adapters 1. Der zweite Adapterteil 101 ist beispielsweise in Fig. 5 (a) dargestellt.

Am zweiten Adapterteil 102 sind die zweiten Anschlussstecker 12 angeordnet, die zum Anschließen des Adapters 1 an das Anschlussmoduls 2 vorgesehen sind. Die zweiten Anschlussstecker 12 sind hier in drei zueinander höhenversetzten Reihen angeordnet. Zudem weisen sie den Winkel α zur Erstreckungsrichtung 41, das ist hier die vertikale Richtung 4, auf.

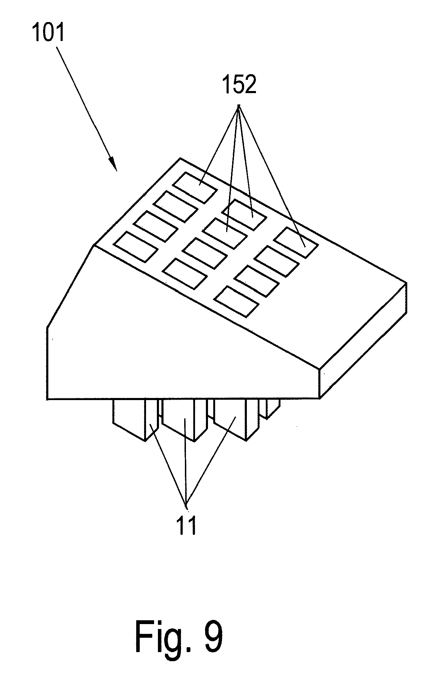

Zudem sind am zweiten Adapterteil 102 erste Zwischenstecker 151 vorgesehen, mit denen der zweite Adapterteil 102 elektrisch mit ersten Zwischengegensteckern 152 (s. Fig. 9) an dem ersten Adapterteil 101 verbindbar ist. Die ersten Zwischenstecker 151 erstrecken sich ebenfalls in dem Winkel α zur vertikalen Richtung 4.

Das Aufstecken des zweiten Adapterteils 102 ist besonders einfach durch Verschieben des zweiten Adapterteils 102 in die Einsteckrichtung 43 im Winkel α zur vertikalen Richtung 4 möglich.

Der zweite Adapterteil 102 ist in einem zweiten Adaptergehäusetell 142 angeordnet, dass vorzugsweise starr ausgebildet ist, und vorzugsweise aus einem Isolierstoff (insbesondere einem Kunststoff) besteht. Um ein Belüften des Anschlussmoduls 2 im Montagezustand M zu ermöglichen, sind im zweiten Adaptergehäuseteil 142 Lüftungsschlitze 131 vorgesehen.

Das zweite Adaptergehäuseteil 142 ist hier als ein Rahmenteil ausgebildet, in das ein Adapterinnenteil 1421 einrastbar ist. Dafür sind Verrastmittel 1423 vorgesehen, mit denen das Adapterinnenteil 1421 im zweiten Adaptergehäuseteil 142 verrastbar ist.

Eine Demontage des zweiten Adapterteils 102 wird noch weiter vereinfacht, indem am zweiten Adapterteil 102 eine Handhabung 16 vorgesehen ist. Die Handhabung 16 ist als ein in eine Schwenkrichtung 46 um eine Schwenkachse 45 schwenkbarer Hebel ausgebildet. Im Folgenden werden die Begriffe Handhabung 16 und Hebel synonym verwendet.

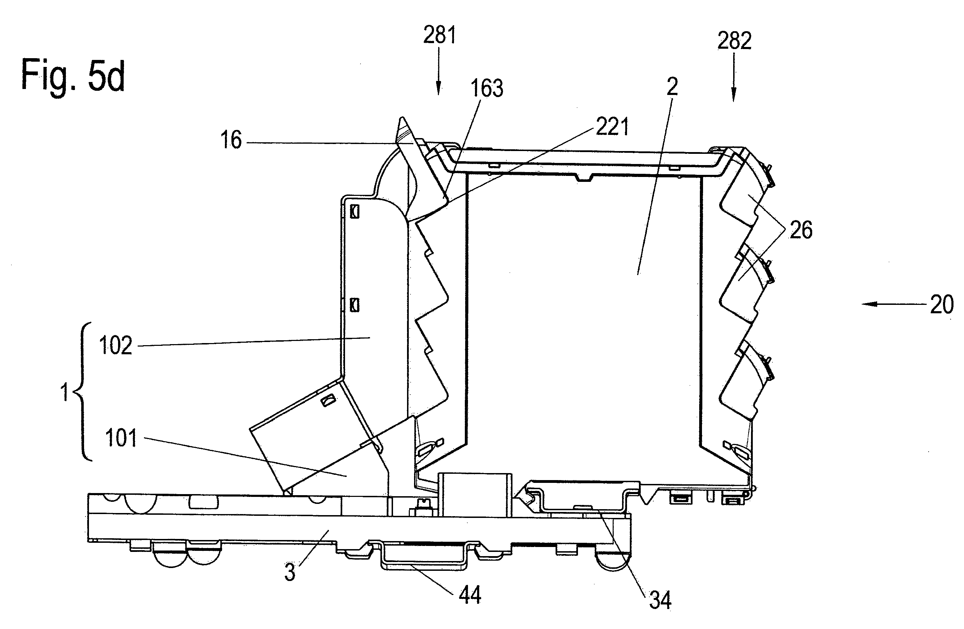

Der Hebel 16 weist einen ersten Schenkel 161 und einen zweiten Schenkel 162 auf, die durch einen Querschenkel 160 miteinander verbunden sind. Der Querschenkel 163 bildet ein Griffteil. Der Hebel 16 ist so am zweiten Adapterteil 102 angeordnet, dass er dieses umgreift. An beiden Schenkeln 161, 162 ist jeweils eine Kontur 163 vorgesehen, die mit einer Gegenkontur 221 (s. Fig. 5(d)) am Anschlussmodul 2 zusammenwirkt. Bei am Anschlussmodul 2 angeordnetem Adapter 1 rollt sich die Kontur 163 beim Verschwenken des Hebels 16 in die Schwenkrichtung 46 an der Gegenkontur 221 ab, so dass der zweite Adapterteil 102 gegen die Einsteckrichtung 43 verschoben, und dadurch aus dem Anschlussmodul 2 heraus gehoben wird.

In Fig. 4 (b) ist ein Befestigungsmittel 17 sichtbar, mit dem der zweite Adapterteil 102 am ersten Adapterteil 101 befestigbar ist. Dieser ist hier als ein Schnapphaken ausgebildet. Im Folgenden werden die Begriffe Befestigungsmittel 17 und Schnapphaken synonym verwendet. Die Fig. 4 (c) zeigt eine Steckseite 47 des zweiten Adapterteils 102, die Fig. 4 (d) eine Rückseite 48 des zweiten Adapterteils 102. Im Schnittbild der Fig. 4 (g) ist sichtbar, dass die zweiten Anschlussstecker 12 und die ersten Zwischenstecker 151 als Federkraftklemmen ausgebildet sind.

Fig. 5 (a) zeigt die Anordnung des Adapters 1 an der Adapterseite 281 eines elektrischen Anschlussmoduls 2 und an eine weitere Ausführungsform des Elektronikmoduls 3. An der der Adapterseite 281 gegenüberliegenden Anschlussseite 282 sind auch bei diesem Anschlussmodul 2 Steckanschlüsse 26 vorgesehen. Die Anschlussgegenstecker 22 des Anschlussmoduls 2 sind hier nicht sichtbar. Sie erstrecken sich aber in analoger Weise zur Ausführungsform der Fig. 2 (a) im Winkel α zur Erstreckungsrichtung 41.

Das Elektronikmodul 3 dieser Ausführungsform ist ebenfalls als eine Leiterplattenanordnung ausgebildet. Diese unterscheidet sich aber von der der Fig. 3 darin, dass die ersten Anschlussstecker 11, die am ersten Adapterteil 101 angeordnet sind, in Steckanschlüsse 3711 eines ersten Anschlussfeldes 371 eingesteckt sind. Zudem weist dieses Elektronikmodul 3 ein zweites Anschlussfeld 372 für andere/weitere elektrische Baugruppen und Module (nicht gezeigt) auf.

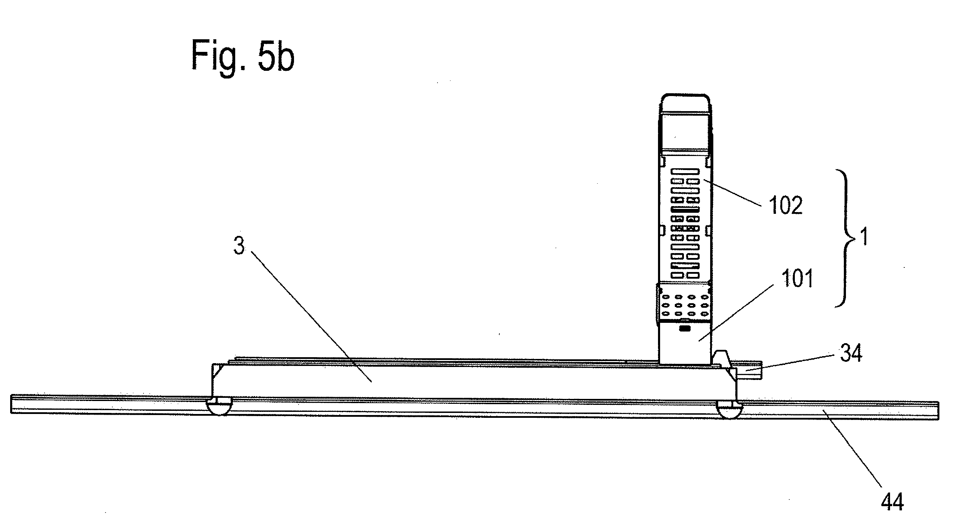

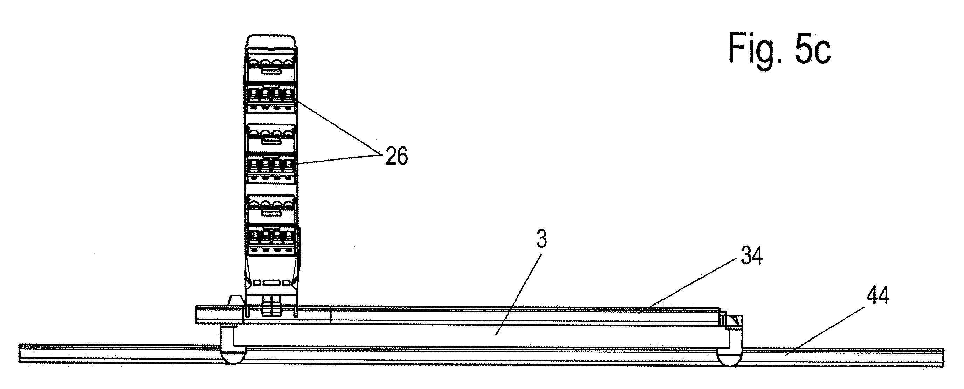

In der Seitenansicht der Fig. 5 (b) ist die Rückseite des Adapters 1 sichtbar, in der Seitenansicht der Fig. 5 (c) eine Stirnseite 20 des Anschlussmoduls 2.

In der Seitenansicht der Fig. 5(d) sind die Kontur 163 des Hebels 16 und die Gegenkontur 221 des Anschlussmoduls dargestellt.

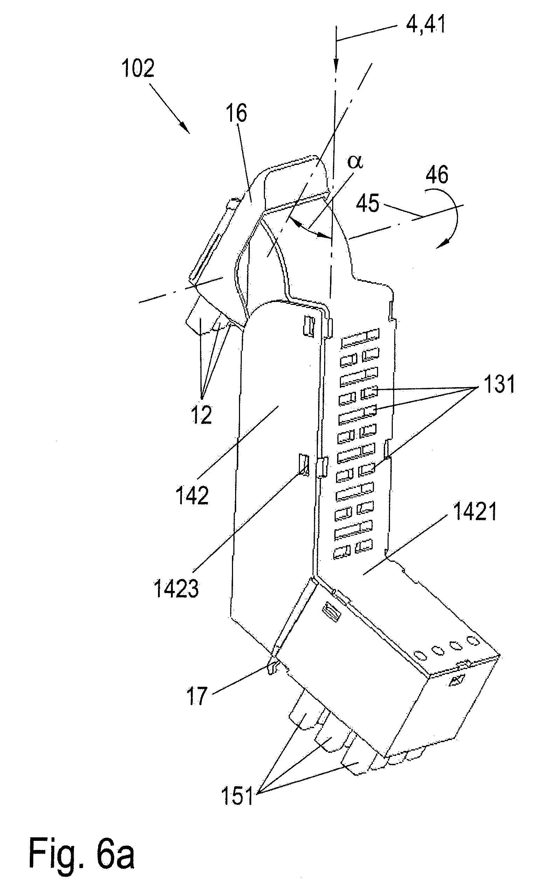

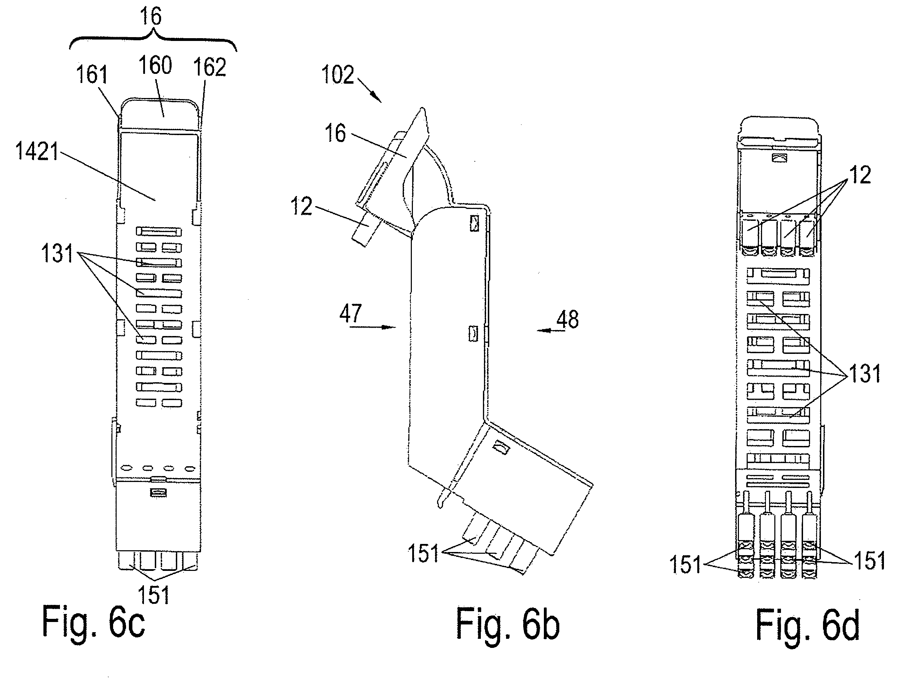

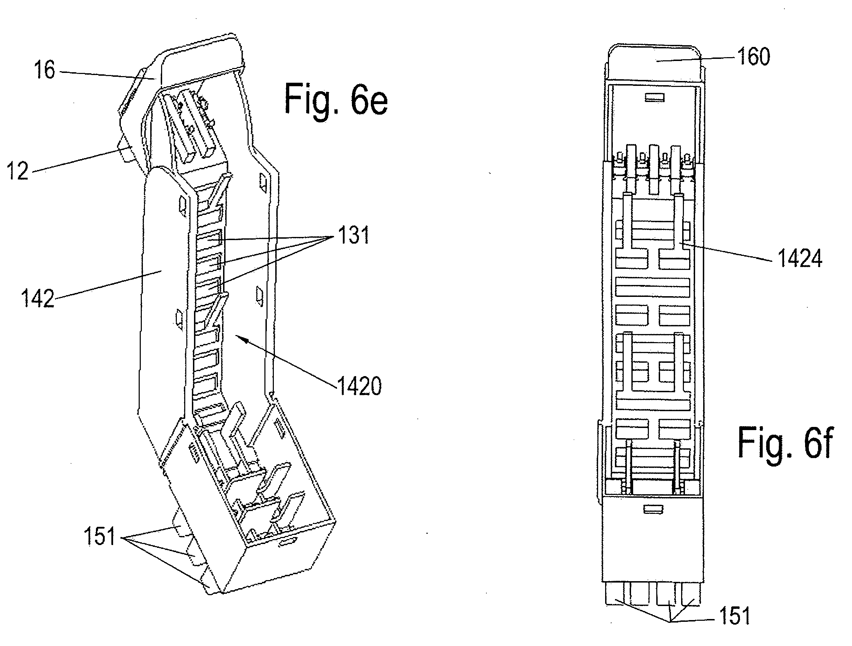

Der zweite Adapterteil 102 der Fig. 6 weist nur eine Reihe zweiter Anschlussstecker 12 auf, die auf derselben Höhe angeordnet sind. Dadurch sind an der Steckseite 47 des zweiten Adapterteils 102 eine Vielzahl Belüftungsschlitze 131 anordbar, durch die das Anschlussmodul 2 besonders gut belüftbar ist. Dies zeigen die Fig. 6 (c) und (d), wobei die Fig. 6 (c) die Steckseite 47 und die Fig. 6 (d) die Rückseite 48 des zweiten Adapterteils 102 zeigen.

Die Fig. 6 (e) und (f) zeigen das als Rahmenteil ausgebildete zweite Adaptergehäuseteil 142 ohne das Adapterinnenteil 1421, so dass ein Innenraum 1420 des zweiten Adaptergehäuseteils 142 sichtbar ist. Dadurch sind als Zungen ausgebildete Isolieroder Abschirmmittel 1424 sichtbar, die sich in den Innenraum 1420 hinein erstrecken.

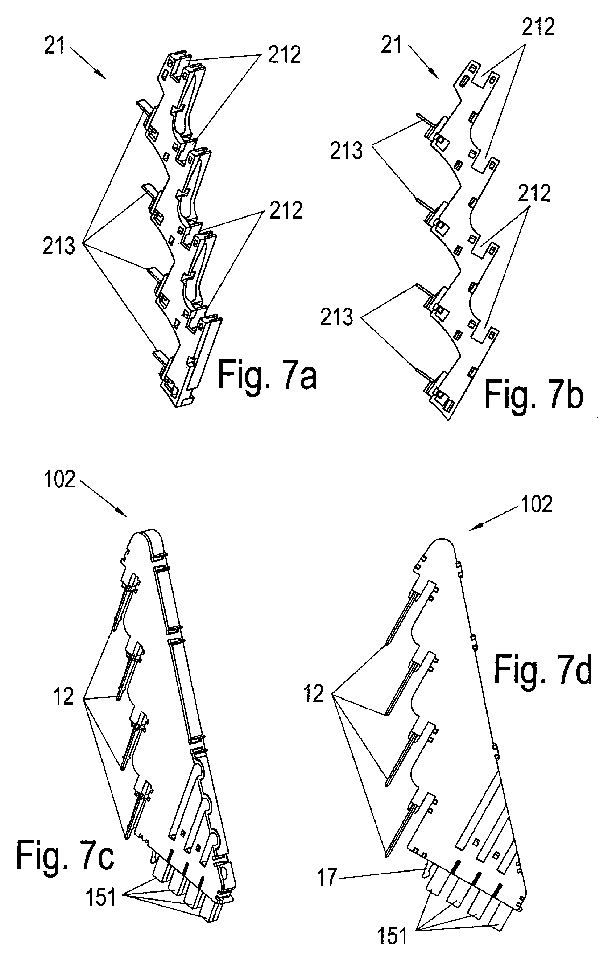

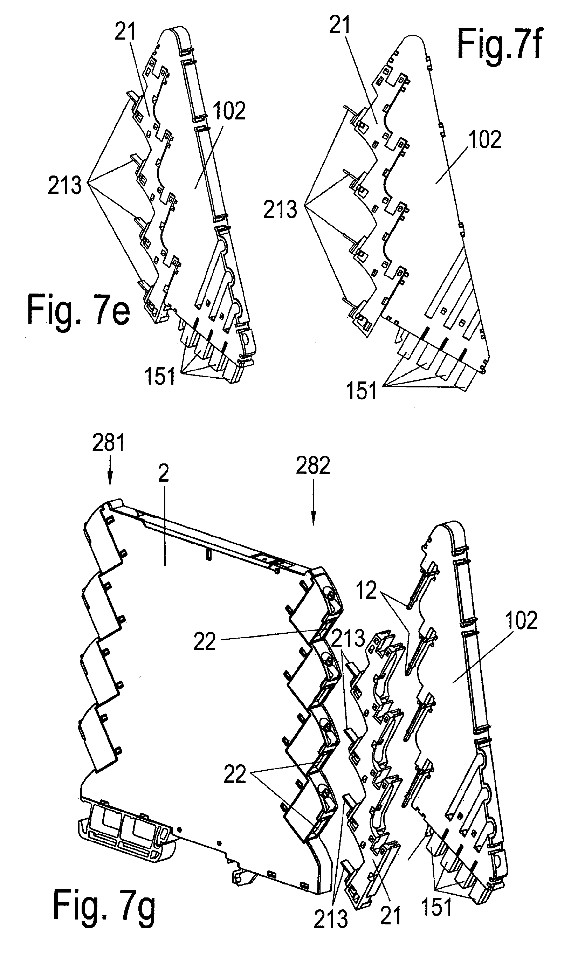

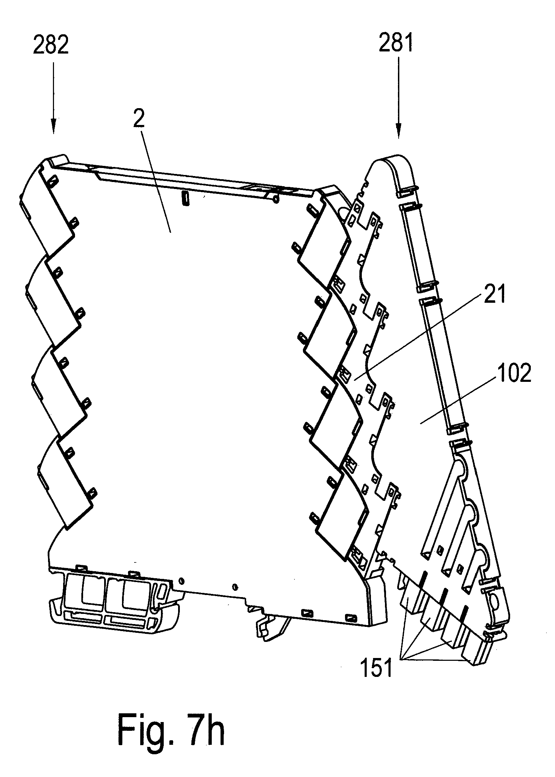

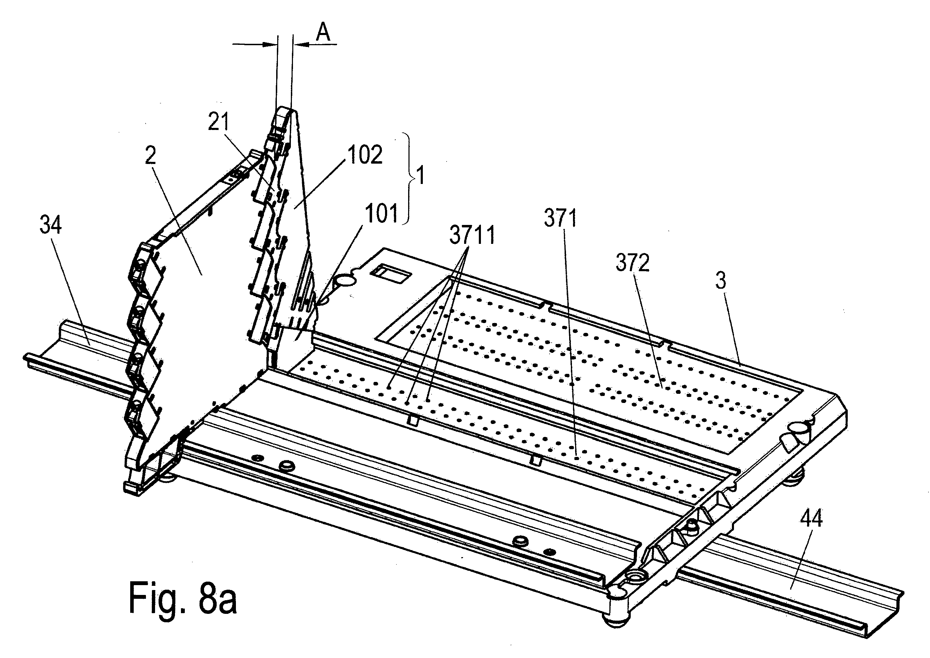

Die Fig. 7 zeigt in (a) ein Zwischenmodul 21, mit dem ein Abstand A zwischen dem Anschlussmodul 2 und dem zweiten Adapterteil 101 (s. Fig. 8(a)) veränderbar ist, und das zudem oder alternativ zum Verändern der Steckrichtung und/oder Verschaltung und/oder zum Anordnen weiterer Elektronik nutzbar ist. Der Abstand A ist durch eine Breite des Zwischenmoduls 21 bestimmt. Durch die Veränderung des Abstandes A zwischen dem Anschlussmodul 2 und dem zweiten Adapterteil 102 werden andere Steckanschlüsse 3711 des ersten Anschlussbusses 371 kontaktiert.

Dafür weist das Zwischenmodul 21 ein oder mehrere zweite Zwischengegenstecker 212 auf, in die die zweiten Anschlussstecker 12 des zweiten Adaptermoduls 102 einsteckbar sind. Die zweiten Zwischengegenstecker 212 sind elektrisch mit zweiten Zwischenkontakten 213 verbunden, die sich in einem Winkel von hier 90° zu den zweiten Anschlusssteckern 12 erstrecken und die elektrisch an die zweiten Anschlussstecker 22 des Anschlussmoduls 2 anschließbar sind.

Die Fig. 7 (a) und (b) zeigen das Zwischenmodul 21 mit den hier als Buchsen ausgebildeten zweiten Zwischengegensteckern 212 und den hier als Kontaktplatten ausgebildeten zweiten Zwischenkontakte 213 in einer perspektivischen und in einer Seitenansicht. Die Fig. 7 (c) und (d) zeigen das zweite Adapterteil 102 in einer perspektivischen und in einer Seitenansicht. Die Fig. 7 (e) und (f) zeigen das am zweiten Adapterteil 102 angeordnete Zwischenmodul 21 in einer perspektivischen und in einer Seitenansicht. Die Fig. 7 (g) zeigt das Anschlussmodul 2, das Zwischenmodul 21 und den zweiten Adapterteil 102 in einer explosionsartigen Ansicht. Und die Fig. 7 (h) zeigt eine montierte Anordnung des Zwischenmoduls 21 mit dem zweiten Adapterteil 102 am Anschlussmodul 2 in einer perspektivischen Ansicht.

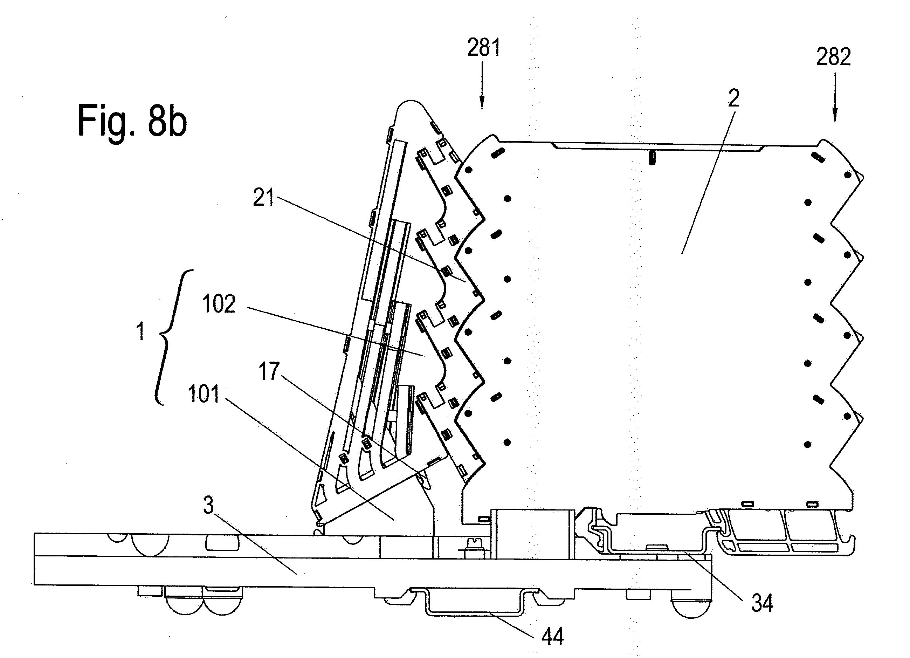

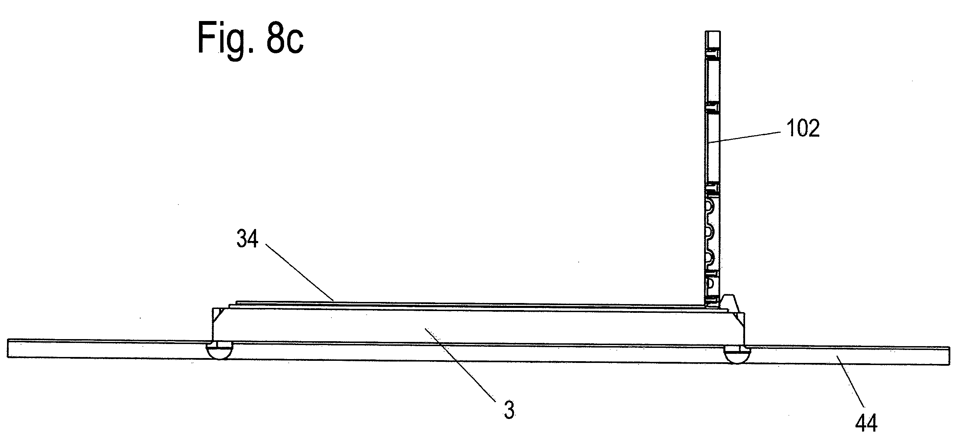

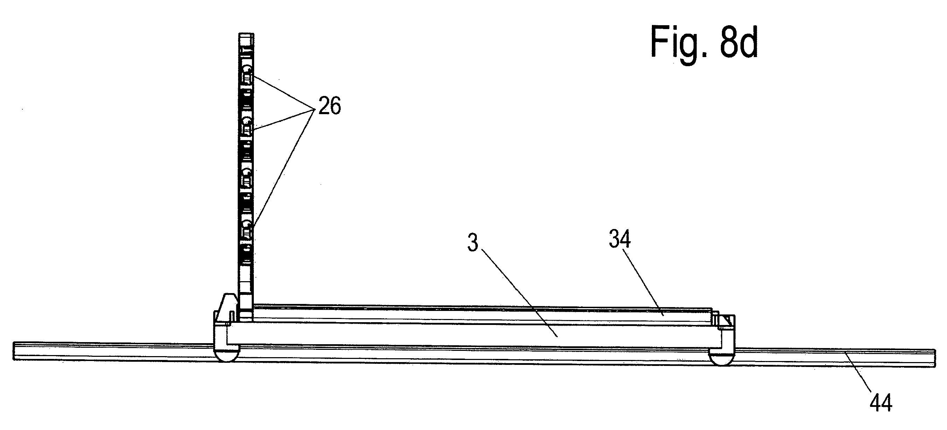

Die Fig. 8 zeigen die Anordnung der Fig. 7(g) an der Elektronikanordnung/Backplane 3. Bei dieser Ausführungsform werden aufgrund des durch das Zwischenmodul 21 veränderten Abstandes A andere Steckanschlüsse/Busleitungen der Elektronikanordnung/Backplane 3 kontaktiert.

Auch hier zeigt die Fig. 8 (c) eine Seitenansicht, in der die Rückseite 48 des Adapters 1 sichtbar ist, und die Fig. 8 (d) eine Seitenansicht, in der die Stirnseite 20 des Anschlussmoduls 2 sichtbar ist. In Fig. 8 (b) ist die Befestigung des zweiten Adapterteils 102 am ersten Adapterteil 101 mittels des Schnapphakens 17 sichtbar.

Fig. 9 zeigt das erste Adapterteil 101 der Fig. 5 (a). Es weist die ersten Zwischengegenstecker 152 auf, die zum Kontaktieren der ersten Zwischenstecker 151 des zweiten Adapterteils 102 vorgesehen sind. Diese sind hier als Buchsen ausgebildet. Zudem weist es die ersten Anschlussstecker 11 auf, die die Steckanschlüsse/Busleitungen der Elektronikanordnung/Backplane 3 kontaktieren.

Die Anzahl, Anordnung und Ausbildung als Buchsen und/oder Stecker der ersten und zweiten Anschlussstecker 11, 12 und Anschlussgegenstecker 31, 22 sowie der ersten und zweiten Zwischenstecker 151, 212 und Zwischengegenstecker 152 beziehungsweise Zwischenkontakte 213 ist in Abhängigkeit von der zu realisierenden Schaltung veränderbar.

**Bezugszeichenliste**

| | |
|---|---|
| 1 | Adapter |
| 101 | Erster Adapterteil |
| 102 | Zweiter Adapterteil |
| 11 | Erster Anschlussstecker |
| 111 | Elektrischer Kontakt |
| 112 | Zweiter Anschlussstecker |
| 13 | Lüftungsöffnung |
| 131 | Lüftungsschlitz |
| 14 | Adaptergehäuse |
| 141 | Erster Adaptergehäuseteil |
| 142 | Zweiter Adaptergehäuseteil |
| 1420 | Innenraum |
| 1421 | Adapterinnenteil |
| 1423 | Verrastmittel |
| 1424 | Isoliermittel / Abschirmmittel |
| 151 | Erster Zwischenstecker |
| 152 | Erster Zwischengegenstecker |
| 16 | Handhabung, Hebel |
| 160 | Querschenkel, Griffteil |
| 161 | Erster Schenkel |
| 162 | Zweiter Schenkel |
| 162 | Kontur |
| 17 | Befestigungsmittel, Schnapphaken |
| 2 | Anschlussmodul, Steuermodul |
| 20 | Stirnseite |
| 21 | Zwischenmodul |
| 212 | Zweiter Zwischenstecker |
| 213 | Zweiter Zwischenkontakt |
| 22 | Zweiter Anschlussgegenstecker |
| 221 | Gegenkontur |
| 23 | Kühlöffnungen |
| 24 | Rastmittel |
| 25 | Betättgungsmittel |
| 26 | Steckanschluss |
| 27 | Standard- Anschlussstecker |
| 281 | Adapterseite |
| 282 | Anschlussseite |
| 29 | Unterseite des Anschlussmoduls |
| 3 | Elektronikanordnung, insbesondere Leiterplattenanordnung, Backplane |
| 31 | Erster Anschlussgegenstecker, Einstecköffnung |
| 32 | Trennwand |
| 321 | Rückwand |
| 33 | Einschubraum, Slot |
| 34 | Erste Tragschiene |
| 341 | Rastschenkel |
| 35 | Anschlussbus |
| 351 | Leiterbahnen |
| 36 | Leiterplattengehäuse |
| 371 | Erstes Anschlussfeld |
| 372 | Zweites Anschlussfeld |
| 38 | Rastmittel |
| 4 | Vertikale Richtung |
| 41 | Erstreckungsrichtung |
| 42 | Schienenrichtung |
| 43 | Einsteckrichtung |
| 44 | Zweite Tragschiene |
| 45 | Schwenkachse |
| 46 | Schwenkrichtung |
| 47 | Steckseite |
| 48 | Rückseite |
| Δh | Höhendifferenz |
| α | Winkel |
| M | Montagezustand |
| A | Abstand |

## Patentansprüche

1. Anordnung mit einem elektrischen Anschlussmodul (2) und einer Elektronikanordnung, insbesondere Leiterplattenanordnung, (3), **gekennzeichnet durch**
a. einen Adapter (1) als elektrischer Verbinder zwischen dem etektrischen Anschlussmodul (2) und der Elektronikanordnung, insbesondere der Leiterplattenanordnung (3),
b. wobei der Adapter mindestens einen ersten Anschlussstecker (11) und mindestens einen zweiten Anschlussstecker (12) aufweist,
c. wobei sich der wenigstens eine erste Anschlussstecker (11) in eine Erstreckungsrichtung (41) erstreckt und wobei sich der wenigstens eine zweite Anschlussstecker (12) In einem vorgegebenen Winkel (α) zur Erstreckungsrichtung (41) erstreckt,
d. wobei sich die zweiten Anschlussstecker **(12) im** Winkel (α) zu der vertikalen Richtung (4) erstrecken,
e. wobei der Winkel ((α) 20-70° beträgt.

2. Anordnung (1) nach Anspruch 1, **dadurch gekennzeichnet, dass** die ersten und zweiten Anschlussstecker (11) in einem vorzugsweise starren Adaptergehäuse (14) angeordnet und elektrisch miteinander verbunden sind.

3. Anordnung nach Anspruch 1 oder 2, **dadurch gekennzeichnet, dass** der Winkel (α) 30 - 50° beträgt.

4. Anordnung nach einem der vorherigen Ansprüche **dadurch gekennzeichnet, dass** der Adapter (1) einen ersten Adapterteil (101) und einen zweiten Adapterteil (102) umfasst, wobei am ersten Adapterteil (101) der erste Anschlussstecker (11), und am zweiten Adapterteil (102) der zweite Anschlussstecker (12) angeordnet ist und/oder dass die Adapterteile (101, 102) in-, an- oder aufeinander steckbar oder schiebbar sind.

5. Anordnung nach Anspruch 4, **dadurch gekennzeichnet, dass** am zweiten Adapterteil (102) Zwischenstecker (151), und am ersten Adapterteil (101) Zwischengegenstecker (152) vorgesehen sind, wobei vorzugsweise die Zwischenstecker (151) und die Zwischengegenstecker (152) im Winkel (α) zur Erstreckungsrichtung (41) angeordnet sind.

6. Anordnung nach einem der vorherigen Ansprüche **dadurch gekennzeichnet, dass** am zweiten Adapterteil (102) eine Handhabung (16) zum Lösen des zweiten Adapterteils (102) vom Anschlussmodul (2) vorgesehen ist.

7. Anordnung nach einem der vorherigen Ansprüche, **dadurch gekennzeichnet, dass** im Adaptergehäuse (14) oder an einem oder mehreren Adaptergehäuseteilen (141, 142) wenigstens eine Lüftungsöffnung (13) oder mehrere Belüftungsschlitze (131) zum Belüften des elektrischen Anschlussmoduls (2) vorgesehen ist oder sind.

8. Anordnung nach einem der vorherigen Ansprüche, **dadurch gekennzeichnet, dass** der erste Anschlussstecker (11) und/oder die zweiten Anschlussstecker (12) einen, zwei oder mehr elektrische Kontakte (111) umfassen.

9. Anordnung nach einem der vorherigen Ansprüche, **dadurch gekennzeichnet, dass** zwischen dem wenigstens einen ersten Anschlussstecker (11) und dem wenigstens einen zweiten Anschlussstecker (12) wenigstens ein elastisches Element, insbesondere ein Federelement, vorgesehen ist.

10. Anordnung nach einem der vorherigen Ansprüche, **dadurch gekennzeichnet, dass** einzelne der Anschlussstecker über eine Schaltung oder direkt über elektrische Verbindungen, vorzugsweise starre Stromschienen oder Leitungen, verbunden sind oder an diesen ausgebildet sind

11. Anordnung nach einem der vorstehenden Ansprüche, **dadurch gekennzeichnet, dass** die Elektronikanordnung, insbesondere Leiterplattenanordnung (3) vorzugsweise einen internen Leiterbus umfasst., und der Adapter (1) das elektrische Anschlussmoduls (2) elektrisch mit dem Leiterbus verbindet.

12. Anordnung nach einem der vorstehenden Ansprüche, **dadurch gekennzeichnet, dass** die Elektronikanordnung, insbesondere Leiterplattenanordnung, (3) ein Gehäuse, insbesondere ein Leiterplattengehäuse (36) aufweist.

13. Anordnung nach einem der vorstehenden Ansprüche, **dadurch gekennzeichnet, dass** an dem Gehäuse, insbesondere dem Leiterplattengehäuse (36) mehrere nebeneinander angeordnete Einschubräume (33) ausgebildet sind, die jeweils zur Aufnahme eines elektrischen Anschlussmoduls (2) vorgesehen sind, wobei vorzugsweise in jedem Einschubraum (33) ein erster Anschlussgegenstecker (31) vorgesehen ist, der korrespondierend zu dem ersten Anschlussstecker (11) des Adapters ausgebildet ist.

14. Anordnung nach einem der Ansprüche 1 - 14, **dadurch gekennzeichnet, dass** die Elektronikanordnung, insbesondere Leiterplattenanordnung, (3) zumindest ein erstes Anschlussfeld (171) aufweist, an das die ersten Anschlussstecker (11) anschließbar sind.

15. Anordnung nach einem der vorstehenden Ansprüche, **dadurch gekennzeichnet, dass** die Elektronikanordnung, insbesondere Leiterplattenanordnung, (3), insbesondere das Gehäuse (36), eine erste, vorzugsweise separate, Tragschiene (34) aufweist, an der die elektrischen Anschlussmodule (2) lösbar befestigbar sind, wobei vorzugsweise an der Tragschiene (34) ein Anschlussbus (35) vorgesehen ist.

16. Anordnung nach einem der vorstehenden Ansprüche, **dadurch gekennzeichnet, dass** jedes elektrische Anschlussmodul (2) zumindest einen zweiten Anschlussgegenstecker (22) umfasst, der korrespondierend zu dem oder den zweiten Anschlusssteckern (12) des Adapters (1) ausgebildet ist, und/oder dass jedes Anschlussmodul (2) ein Betätigungsmittel (25) zum Lösen des Anschlussmoduls (2) von der ersten Tragschiene (34) umfasst.

17. Anordnung nach einem der vorstehenden Ansprüche, **dadurch gekennzeichnet, dass** derAdapter (1) quer zu einer Leiterplatte des Leiterplattengehäuses und parallel des elektrischen Anschlussmoduls (2) vorgesehen ist.

## Claims

1. An arrangement having an electrical connection module (2) and an electronics arrangement, particularly a printed circuit board arrangement (3), **characterized by**
a) an adapter (1) as the electrical connector between the electrical connection module (2) and the electronics arrangement, in particular the printed circuit board arrangement (3),
b) wherein the adapter has at least one first connector (11) and at least one second connector (12),
c) wherein the at least one first connector (11) extends in an extension direction (41) and wherein the at least one second connector (12) extends at a predefined angle (α) relative to the extension direction (41),
d) wherein second connectors (12) extend at an angle (α) relative to the vertical direction (4),
e) wherein the angle (α) is 20° to 70°.

2. The arrangement (1) according to claim 1, **characterized in that** the first and second connectors (11) are arranged in a preferably rigid adapter housing (14) and are electrically connected to one another.

3. The arrangement according to claim 1 or 2, **characterized in that** the angle (α) is 30° to 50°.

4. The arrangement according to any of the preceding claims, **characterized in that** the adapter (1) comprises a first adapter part (101) and a second adapter part (102), wherein the first connector (11) is arranged on the first adapter part (101), and the second connector (12) is arranged on the second adapter part (102), and/or the adapter parts (101, 102) can be plugged or slid into, onto or on top of each other.

5. The arrangement according to claim 4, **characterized in that** plug adapters (151) are provided on the second adapter part (102), and mating connectors (152) are provided on the first adapter part (101), wherein preferably the plug adapters (151) and the mating connectors (152) are arranged at an angle (α) relative to the extension direction (41).

6. The arrangement according to any of the preceding claims, **characterized in that** a handling device (16) for detaching the second adapter part (102) from the connection module (2) is provided on the second adapter part (102).

7. The arrangement according to any of the preceding claims, **characterized in that** in the adapter housing (14) or on one or multiple adapter housing parts (141, 142) at least one vent opening (13) or multiple vent slots (131) is/are provided for the ventilation of the electrical connector module (2)

8. The arrangement according to any of the preceding claims, **characterized in that** the first connector (11) and/or the second connector (12) comprises one, two or more electrical contacts (111).

9. The arrangement according to any of the preceding claims, **characterized in that** between the at least one first connector (11) and the at least one second connector (12) at least one elastic element, in particular a spring element, is provided.

10. The arrangement according to any of the preceding claims, **characterized in that** individual connectors are connected via a circuit or directly via electrical connections, preferably bus bars or lines, or are formed thereon.

11. The arrangement according to any of the preceding claims, **characterized in that** the electronics arrangement, in particular printed circuit board arrangement (3), preferably comprises an internal bus bar, and the adapter (1) electrically connects the electrical connection module (2) to the bus bar.

12. The arrangement according to any of the preceding claims, **characterized in that** the electronics arrangement, in particular printed circuit board arrangement (3), comprises a housing, in particular a circuit board box (36).

13. The arrangement according to any of the preceding claims, **characterized in that** on the housing, in particular on the circuit board box (36), multiple adjacently arranged insert spaces (33) are formed, which are respectively provided for the insertion of an electrical connection module (2), wherein preferably in each insert space (33) a first mating connector (31) is provided, which is formed corresponding to the first connector (11) of the adapter.

14. The arrangement according to any of the claims 1 to 14, **characterized in that** the electronics arrangement, in particular the printed circuit board arrangement (3), comprises at least one first connector panel (171), to which the first connectors (11) can be connected.

15. The arrangement according to any of the preceding claims, **characterized in that** the electronics arrangement, in particular the printed circuit board arrangement (3), especially the housing (36),comprises one first, preferably separate, mounting rail (34), onto which the electrical connection modules (2) can be detachably connected, wherein preferably a connection bus (35) is provided on the mounting rail (34).

16. The arrangement according to any of the preceding claims, **characterized in that** each electrical connection module (2) comprises at least one second mating connector (22), which is formed corresponding to the second connector(s) (12) of the adapter (1), and/or that each connection module (2) comprises an actuating means (25) for detaching the connection module (2) from the first mounting rail (34).

17. The arrangement according to any of the preceding claims, **characterized in that** the adapter (1) is provided transverse relative to a printed circuit board of the circuit board box and parallel to the electrical connection module (2).

## Revendications

1. Dispositif avec un module de raccordement électrique (2) et un dispositif électronique, en particulier un dispositif de carte de circuits imprimés (3), **caractérisé en ce qu'**il comprend :
a. un adaptateur (1) servant de connecteur électrique entre le module de raccordement électrique (2) et le dispositif électronique, en particulier le dispositif de carte de circuits imprimés (3),
b. l'adaptateur présentant au moins un premier connecteur de raccordement (11) et au moins un deuxième connecteur de raccordement (12),
c. l'au moins un premier connecteur de raccordement (11) s'étendant dans une direction d'extension (41) et l'au moins un deuxième connecteur de raccordement (12) s'étendant en formant un angle (α) prédéterminé par rapport à la direction d'extension (41),
d. les deuxièmes connecteurs de raccordement (12) s'étendant selon l'angle (α) par rapport à la verticale (4),
e. lequel angle (α) mesure de 20° à 70°.

2. Dispositif (1) selon la revendication 1, **caractérisé en ce que** les premiers et deuxièmes connecteurs de raccordement (11) sont disposés dans un boîtier d'adaptateur (14), de préférence rigide, et connectés électriquement les uns aux autres.

3. Dispositif selon la revendication 1 ou 2, **caractérisé en ce que** l'angle (α) mesure de 30° à 50°.

4. Dispositif selon l'une des revendications précédentes, **caractérisé en ce que** l'adaptateur (1) comprend une première partie d'adaptateur (101) et une deuxième partie d'adaptateur (102), le premier connecteur de raccordement (11) étant disposé sur la première partie d'adaptateur (101) et le deuxième connecteur de raccordement (12) sur la deuxième partie d'adaptateur (102) et/ou **en ce que** les parties d'adaptateur (101, 102) peuvent être embrochées ou insérées l'une dans, sur ou par-dessus l'autre.

5. Dispositif selon la revendication 4, **caractérisé en ce que** des connecteurs intermédiaires (151) sont prévus sur la deuxième partie d'adaptateur (102) et des connecteurs intermédiaires complémentaires (152) sur la première partie d'adaptateur (101), les connecteurs intermédiaires (151) et les connecteurs intermédiaires complémentaires (152) étant de préférence disposés selon l'angle (α) par rapport à la direction d'extension (41).

6. Dispositif selon l'une des revendications précédentes, **caractérisé en ce qu'**un organe de manipulation (16) est prévu sur la deuxième partie d'adaptateur (102) pour détacher la deuxième partie d'adaptateur (102) du module de raccordement (2).

7. Dispositif selon l'une des revendications précédentes, **caractérisé en ce qu'**au moins une ouverture d'aération (13) ou plusieurs fentes d'aération (131) sont prévues dans le boîtier d'adaptateur (14) ou sur une ou plusieurs parties de boîtier d'adaptateur (141, 142) pour aérer le module de raccordement électrique (2).

8. Dispositif selon l'une des revendications précédentes, **caractérisé en ce que** le premier connecteur de raccordement (11) et/ou le deuxième connecteur de raccordement (12) comprennent un, deux ou plusieurs contacts électriques (111).

9. Dispositif selon l'une des revendications précédentes, **caractérisé en ce qu'**il est prévu entre l'au moins un premier connecteur de raccordement (11) et l'au moins un deuxième connecteur de raccordement (12) au moins un élément élastique, en particulier un élément de ressort.

10. Dispositif selon l'une des revendications précédentes, **caractérisé en ce que** certains des connecteurs de raccordement sont connectés par l'intermédiaire d'un circuit ou directement par des connexions électriques, de préférence des barres collectrices rigides ou des lignes, ou sont formés sur celles-ci.

11. Dispositif selon l'une des revendications précédentes, **caractérisé en ce que** le dispositif électronique, en particulier un dispositif de carte de circuits imprimés (3), comprend de préférence un bus de conducteurs interne et l'adaptateur (1) connecte électriquement le module de raccordement électrique (2) au bus de conducteurs.

12. Dispositif selon l'une des revendications précédentes, **caractérisé en ce que** le dispositif électronique, en particulier un dispositif de carte de circuits imprimés (3), présente un boîtier, en particulier un boîtier pour carte de circuits imprimés (36).

13. Dispositif selon l'une des revendications précédentes, **caractérisé en ce que** plusieurs compartiments d'insertion (33) disposés les uns à côté des autres, prévus chacun pour recevoir un module de raccordement électrique (2), sont formés sur le boîtier, en particulier sur le boîtier pour carte de circuits imprimés (36), un premier connecteur de raccordement complémentaire (31) qui correspond au premier connecteur de raccordement (11) de l'adaptateur étant formé de préférence dans chaque compartiment d'insertion (33).

14. Dispositif selon l'une des revendications 1 à 14, **caractérisé en ce que** le dispositif électronique, en particulier un dispositif de carte de circuits imprimés (3) présente au moins un premier panneau de raccordement (171) auquel les premiers connecteurs de raccordement (11) peuvent être raccordés.

15. Dispositif selon l'une des revendications précédentes, **caractérisé en ce que** le dispositif électronique, en particulier un dispositif de carte de circuits imprimés (3) et en particulier le boîtier (36), présente un premier rail de support (34), de préférence séparé, sur lequel les modules de raccordement électriques (2) peuvent être fixés de manière amovible, un bus de raccordement (35) étant de préférence prévu sur le rail de support (34).

16. Dispositif selon l'une des revendications précédentes, **caractérisé en ce que** chaque module de raccordement électrique (2) comprend au moins un deuxième connecteur de raccordement complémentaire (22), qui est formé en correspondance avec le ou les deuxièmes connecteurs de raccordement (12) de l'adaptateur (1), et/ou **en ce que** chaque module de raccordement (2) comprend un moyen d'actionnement (25) pour détacher le module de raccordement (2) du premier rail de support (34).

17. Dispositif selon l'une des revendications précédentes, **caractérisé en ce que** l'adaptateur (1) est prévu transversalement par rapport à une carte de circuits du boîtier de carte de circuits imprimés et parallèlement au module de raccordement électrique (2).
